# EUROPÄISCHE PATENTSCHRIFT

(11) **EP 0 940 913 B1**
(45) Veröffentlichungstag und Bekanntmachung des Hinweises auf die Patenterteilung: **30.06.2004**
(21) Anmeldenummer: 99102579.2
(22) Anmeldetag: 11.02.1999
(51) Int. Cl.: H03G 5/22, H03G 1/00

(54) **Rundfunkempfänger für ein Fahrzeug**
Radio receiver for a vehicle
Récepteur radio pour véhicule

(30) Priorität: 03.03.1998 DE 19808818
(43) Veröffentlichungstag der Anmeldung: 08.09.1999
(73) Patentinhaber: Grundig Car InterMedia System GmbH, 90471 Nürnberg (DE)
(72) Erfinder: Nohse, Dieter c/o Grundig AG, 90762 Fürth (DE); Kagerbauer, Gottfried c/o Grundig AG, 90762 Fürth (DE)
(74) Vertreter: Manitz, Finsterwald & Partner

(56) Entgegenhaltungen:
- DE-A- 4 400 865
- US-A- 3 735 275
- US-A- 4 347 404
- US-A- 4 698 842
- US-A- 4 710 962

## Beschreibung

Die vorliegende Erfindung betrifft einen Rundfunkempfänger für ein Fahrzeug, insbesondere einen Rundfunkempfänger zur Verbesserung der Verständlichkeit von Durchsagen bzw. Sprache.

Moderene Rundfunksender senden neben den üblichen Audiosignalen häufig Zusatzsignale, die u. a. zur Information über die aktuelle Verkehrslage dienen. Beispielsweise umfassen die Zusatzsignale bei RDS (Radio Data System) ein Zusatzsignal, das Sender kennzeichnet, die Verkehrsinformationen senden. Ein weiteres Zusatzsignat wird immer dann ausgesendet, wenn eine Durchsage die Verkehrslage betreffend gesendet wird. Will der Nutzer eines Rundfunkempfängers über die aktuelle Verkehrslage informiert werden, können in einem Rundfunkempfänger die genannten Zusatzsignale dazu verwendet werden, einen mit den genannten Zusatzsignalen gekennzeichneten Rundfunksender und damit die Verkehrsdurchsage wiederzugeben, auch wenn momentan ein andrer Rundfunksender oder eine andre Programmquelle, wie z. B. ein CD-Player, wiedergegeben wird.

Wegen der häufig auf das wiederzugebende Audiosignal angewendeten Klangveränderungen mittels z. B. Baß- und Höhenregler oder Loudenesstaste wird die Verständlichkeit der Durchsagen bzw. von Sprache teilweise stark beeinträchtigt. Besonders problematisch in diesem Zusammenhang ist die Anhebung tiefer Töne durch Loudenesstaste und Baßregler, wodurch die Sprache oft als so dumpf empfunden wird, daß sie nicht mehr verständlich ist. Aus der EP 0 330 062 A1 ist ein Rundfunkempfänger für ein Fahrzeug bekannt, der auf der Erkenntnis beruht, daß bei hochwertigen Rundfunkempfängern nach der HiFi-Norm sehr häufig eine starke Anhebung der tiefen Töne erfolgt, die eine subjektiv angenehm empfundene Musikwiedergabe ermöglicht, die aber bei Sprachwiederbabe dazu führt, daß, wegen des dumpfen Klangs, die Verständlichkeit stark eingeschränkt ist. Aus diesem Grund wird bei dem bekannten Rundfunkempfänger, neben einer automatischen Einstellung der Lautstärke auf einen bestimmten, vorgegebenen Pegel, bei Vorliegen eines Sprachsignals, auch für die Anhebung der tiefen Tonanteile automatisch ein vorgegebener Wert eingestellt.

Aus dem vorstehend beschriebenen Stand der Technik geht allerdings nicht hervor, wie das Problem der Sprachverständlichkeit gelöst werden kann, wenn die tiefen Tonanteile besonders stark pegelmäßig angehoben werden und der eingestellte Sender nur schwach zu empfangen ist.

Es ist daher die Aufgabe der vorliegenden Erfindung, einen Rundfunkempfänger für ein Fahrzeug anzugeben, bei dem Durchsagen bzw. Sprache auch dann gut zu verstehen sind, wenn die tiefen Tonanteile besonders stark pegelmäßig angehoben sind und der wiederzugebende Sender nur schwach zu empfangen ist.

Die vorliegende Aufgabe wird bei einem erfindungsgemäßen Rundfunkempfänger für ein Fahrzeug, mit
einem Stereoempfänger zum Empfang eines Audiosignals,
einer Einrichtung zur Untersuchung des empfangenen Audiosignals, die bei Vorliegen einer Durchsage oder von Sprache ein Steuersignal erzeugt,
einer oder mehrerer Einrichtungen zur Anhebung des Pegels niederfrequenter Töne des Audiosignals,
mehrerer Einrichtungen zur Verstärkung des Audiosignals für die Wiedergabe, und
einer Steuereinrichtung zur Steuerung des Rundfunkempfängers, dadurch gelöst, daß
die Steuereinrichtung, sobald die Einrichtung zur Untersuchung des empfangenen Audiosignals das Vorliegen einer Durchsage oder von Sprache erkennt und das entsprechende Steuersignal erzeugt, die Einrichtung oder Einrichtungen zur Anhebung des Pegels niederfrequenter Töne deaktiviert, und an mindestens einer der Einrichtungen zur Verstärkung die Verstärkung um einen vorgegebenen Wert anhebt, um zumindest die Deaktivierung der Einrichtung oder Einrichtungen zur Anhebung des Pegels niederfrequenter Töne auszugleichen, und die Steuereinrichtung den Stereoempfänger auf Monoempfang umschaltet.

Bei dem erfindungsgemäßen Rundfunkempfänger wird dabei von der Überlegung ausgegangen, daß durch die Deaktivierung der Anhebung tiefer Töne die Verständlichkeit von Durchsagen bzw. Sprache verbessert wird, wobei der Höreindruck durch die Anhebung der Lautstärke kaum verändert wird. Die Gleichzeitige Umschaltung auf Monowiedergabe des empfangenen Stereosignals bewirkt zusätzlich, daß auch Durchsagen bzw. Sprache, die von nur schwach empfangbaren Sendern stammen, gut verständlich wiedergegeben werden.

Der Vorteil der Erfindung liegt insbesondere darin, daß Durchsagen bzw. Sprache auch unter ungünstigen Voraussetzungen gut verständlich wahrgenommen werden kann.

Weitere Vorteile der vorliegenden Erfindung ergeben sich aus den abhängigen Ansprüchen sowie der nachfolgenden Beschreibung eines Ausführungsbeispiels anhand einer Figur.

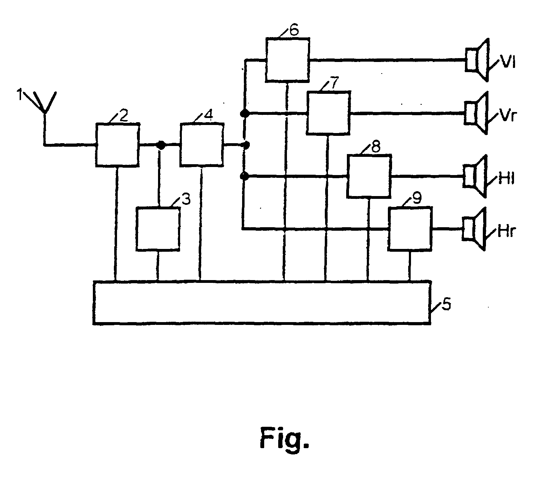

Die einzige Figur zeigt ein Prinzipschaltbild einer Ausführungsform eines erfindungsgemäßen Rundfunkempfängers.

Der Rundfunkempfänger weist eine Antenne 1, einen Stereoempfänger 2 zum Empfang eines Audiosignals, eine Einrichtung 3 zur Untersuchung des vom Stereoempfänger 2 empfangenen Audiosignals, eine Einrichtung 4 zur Anhebung des Pegels niederfrequenter Töne des Audiosignals, mehrere Einrichtungen 6, 7, 8 und 9 zur Verstärkung des Audiosignals und eine Steuereinrichtung 5 zur Steuerung der den Rundfunkempfänger bildenden Einrichtungen 2 bis 9 auf.

Der an sich bekannte Stereoempfänger 2 enthält unter anderem einen Tuner, der das wiederzugebende Stereo-Audiosignal liefert. Der Stereoempfänger 2 wird von der Steuereinrichtung 5, die beispielsweise von einem Mikrocomputer gebildet werden kann, gesteuert, um beispielsweise den Tuner zum Empfang des Rundfunksignals eines bestimmten Senders abzustimmen, dessen auf das Rundfunksignal modulierte Stereo-Audiosignal wiedergegeben werden soll.

Das Stereo-Audiosignal des Stereoempfängers 2 wird an die Einrichtung 3 zur Untersuchung auf Vorliegen eines Sprachsignals bzw. einer Durchsage, die beispielsweise von einem an sich bekannten Verkehrsfunk-Decoder nach dem RDS- oder DAB-Standard gebildet werden kann, und an die Einrichtung 4 zur Anhebung des Pegels niederfrequenter Töne des Audiosignals, welche beispielsweise von einer Loudeness-Schaltung gebildet werden kann, weitergeleitet. Die Aufgabe des Verkehrsfunk-Decoders 3 kann auch von dem Mikroprozessor übernommen werden, der die Steuereinrichtung 5 bildet. Bei Vorliegen eines Sprachsignals, bzw. einer Verkehrsdurchsage, erzeugt der Verkehrsfunk-Decoder 3 ein Steuersignal und gibt es an die Steuereinrichtung 5 weiter.

Zur Wiedergabe wird das Stereo-Audiosignal in der Einrichtung 4 zur Anhebung des Pegels niederfrequenter Töne verarbeitet und an die Eingänge der Verstärker 6, 7, 8 und 9 angelegt, an deren Ausgängen Lautsprecher oder Lautsprechergruppen Vl, Vr, Hl und Hr angeschlossen sind. Zur Wiedergabe des Stereo-Audiosignals sind dazu die Lautsprecher Vl, Hl für den linken und die Lautsprecher Vr, Hr für den rechten Stereokanal vorhanden, wobei die Lautsprecher Vl, Vr im vorderen und die Lautsprecher Hl, Hr im hinteren Bereich des Fahrzeugs angebracht sind. Statt wie in der Figur dargestellt, können auch mehrere Einrichtungen 4 zur Anhebung des Pegels niederfrequenter Töne vorhanden sein, beispielsweise jeweils eine Einrichtung für jeden Stereokanal oder jeweils eine Einrichtung für jeden der Wiedergabewege 6, Vl bzw. 7, Vr bzw. 8, Hl bzw. 9, Hr. Neben der Anhebung des Pegels niederfrequenter Töne kann die Einrichtung 4 auch weitere Klangsteller, zur Beeinflussung des Pegels von z. B. Tiefen und Höhen, oder Lautstärkeregler umfassen. Die Lautstärkeregelung kann auch direkt durch die Veränderung der Verstärkung der Verstärker 6, 7, 8 und 9 durch die Steuereinrichtung 5 bewirkt werden.

Liegt an der Steuereinrichtung 5 das Steuersignal des Verkehrsfunk-Decoders 3 an, deaktiviert die Steuereinrichtung 5 die Einrichtung 4 zur Anhebung der niederfrequenten Töne und erhöht gleichzeitig die Verstärkung an einem oder mehreren der Verstärker 6, 7, 8 und/oder 9 zumindest so weit, um den durch die Dektivierung der Einrichtung 4 zur Anhebung der niederfrequenten Töne entstandenen leiseren Höreindruck zu kompensieren. Weiterhin schaltet die Steuereinrichtung 5 den Stereoempfänger 2 auf Monoempfang um. Dadurch wird der Ausgangspegel des Stereoempfängers 2 erhöht, wodurch insbesondere bei schlecht empfangbaren Senderen eine wesentliche Verbesserung der Verständlichkeit von Durchsagen bzw. Sprache erreicht wird.

Es kann auch vorgesehen sein, daß eine zusätzliche Einrichtung zur Bewertung der Empfangsqualität des jeweils empfangenen Senders verwendet wird, deren Steuersignal zur Auswertung ebenfalls der Steuereinrichtung 5 zugeführt wird. In diesem Fall erfolgt die Umschaltung auf Monoempfang nur wenn die zusätzliche Eirichtung feststellt, daß der eingestellte Sender schlecht empfangen wird.

Weiterhin kann es vorgesehen sein, daß die Steuereinrichtung 5 beim Vorliegen des Steuersignals, welches Sprache bzw. Durchsagen kennzeichnet, die weiteren Klangregler deaktiviert, um eine lineare Wiedergabe des Audiosignals zu bewirken. Darüber hinaus ist es möglich, daß die Steuereinrichtung 5 mehrere der Lautsprecher Vl, Vr, Hl und/oder Hr bei Vorliegen des Steuersignals für Sprache durch Steuerung der Verstärker 6, 7, 8 und/oder 9 deaktiviert.

Die Steuereinrichtung 5 deaktiviert z. B. die Verstärker 7 und 9 des rechten Stereokanals sowie einen der Verstärker des linken Stereokanals, vorzugsweise den Verstärker 8. Dadurch ist in links gesteuerten Fahrzeugen nur noch der Lautsprecher aktiv, der dem Fahrer am nächsten liegt.

Bei rechts gesteuerten Fahrzeugen werden dagegen von der Steuereinrichtung 5 die Verstärker 6 und 8 des linken Stereokanals sowie einer der Verstärker des rechten Stereokanals, vorzugsweise der Verstärker 9 deaktiviert.

## Patentansprüche

1. Rundfunkempfänger für ein Fahrzeug, mit
einem Stereoempfänger (2) zum Empfang eines Audiosignals,
einer Einrichtung zur Untersuchung des empfangenen Audiosignals (3), die bei Vorliegen einer Durchsage oder von Sprache ein Steuersignal erzeugt,
einer oder mehrerer Einrichtungen zur Anhebung des Pegels niederfrequenter Töne des Audiosignals (4),
mehrerer Einrichtungen zur Verstärkung des Audiosignals (6,7,8,9) für die Wiedergabe, und
einer Steuereinrichtung zur Steuerung des Rundfunkempfängers (5), wobei
die Steuereinrichtung (5), sobald die Einrichtung zur Untersuchung des empfangenen Audiosignals (3) das Vorliegen einer Durchsage oder von Sprache erkennt und das entsprechende Steuersignal erzeugt, die Einrichtung oder Einrichtungen zur Anhebung des Pegels niederfrequenter Töne (4) deaktiviert, und an mindestens einer der Einrichtungen zur Verstärkung (6,7,8,9) die Verstärkung um einen vorgegebenen Wert anhebt, um zumindest die Deaktivierung der Einrichtung oder Einrichtungen zur Anhebung des Pegels niederfrequenter Töne (4) auszugleichen, und die Steuereinrichtung (5) den Stereoempfänger (2) auf Monoempfang umschaltet.

2. Rundfunkempfänger nach Anspruch 1,
**dadurch gekennzeichnet,**
**daß** eine weitere Einrichtung vorhanden ist, die die Empfangsqualität des Stereoempfängers (2) ermittelt, und daß die Steuereinrichtung (5) nur dann auf Monoempfang umschaltet, wenn ein Signal von der weiteren Einheit vorliegt, das schlechten Empfang kennzeichnet.

3. Rundfunkempfänger nach Anspruch 1 oder 2,
**dadurch gekennzeichnet,**
**daß** die Steuereinrichtung (5) beim Vorliegen des Steuersignals vorhandene Klangregler deaktiviert, so daß eine lineare Wiedergabe des Audiosignals erfolgt.

4. Rundfunkempfänger nach einem der Ansprüche 1 bis 3,
**dadurch gekennzeichnet,**
**daß** mehrere Lautsprecher oder Lautsprechergruppen (Vl,Vr,Hl,Hr) an den Rundfunkempfänger angeschlossen sind, und daßdie Steuereinrichtung (5) bei Vorliegen des Steuersignals alle Lautsprecher oder Lautsprechergruppen (Vr,Hl,Hr), bis auf den Lautsprecher oder die Lautsprechergruppe, der/die einer im Fahrzeug vorhanden Fahrerposition am nächsten liegt/liegen, durch Steuerung der Einrichtungen zur Verstärkung (6,7,8,9) deaktiviert.

5. Rundfunkempfänger nach einem der Ansprüche 1 bis 3,
**dadurch gekennzeichnet,**
**daß** die Steuereinrichtung (5) bei Vorliegen des Steuersignals die Einrichtungen zur Verstärkung (7,9) des rechten Stereokanals sowie eine der Einrichtungen zur Verstärkung (8) des linken Stereokanals deaktiviert.

6. Rundfunkempfänger nach einem der Ansprüche 1 bis 3,
**dadurch gekennzeichnet,**
**daß** die Steuereinrichtung (5) bei Vorliegen des Steuersignals die Einrichtungen zur Verstärkung (6,8) des linken Stereokanals sowie eine der Einrichtungen zur Verstärkung (9) des rechten Stereokanals deaktiviert.

## Claims

1. Radio receiver for a vehicle, with
a stereo receiver (2) for the reception of an audio signal,
a device for testing the received audio signal (3) which generates a control signal if a broadcast or speech is present,
one or more devices for boosting the level of low-frequency tones of the audio signal (4),
several devices for amplifying the audio signal (6, 7, 8, 9) for reproduction, and
a control device for control of the radio receiver (5),
wherein,
as soon as the device for testing the received audio signal (3) detects the presence of a broadcast or speech and generates the corresponding control signal, the control device (5) deactivates the device or devices for boosting the level of low-frequency tones (4), and at at least one of the devices for amplification (6, 7, 8, 9) boosts the amplification by a predetermined value, in order at least to compensate for deactivation of the device or devices for boosting the level of low-frequency tones (4), and the control device (5) switches the stereo receiver (2) to mono reception.

2. Radio receiver according to claim 1, **characterised in that** there is a further device which determines the reception quality of the stereo receiver (2), and **in that** the control device (5) switches to mono reception only when a signal from the further unit which characterises poor reception is present.

3. Radio receiver according to claim 1 or 2, **characterised in that** if the control signal is present the control device (5) deactivates existing sound controls, so that there is linear reproduction of the audio signal.

4. Radio receiver according to any of claims 1 to 3, **characterised in that** several loudspeakers or loudspeaker assemblies (Vl, Vr, Hl, Hr) are connected to the radio receiver, and **in that** if the control signal is present the control device (5) deactivates all loudspeakers or loudspeaker assemblies (Vr, Hl, Hr) except for the loudspeaker or loudspeaker assembly which is closest to a driver's position existing in the vehicle, by control of the devices for amplification (6, 7, 8, 9).

5. Radio receiver according to any of claims 1 to 3, **characterised in that** if the control signal is present the control device (5) deactivates the devices for amplification (7, 9) of the right stereo channel as well as one of the devices for amplification (8) of the left stereo channel.

6. Radio receiver according to any of claims 1 to 3, **characterised in that** if the control signal is present the control device (5) deactivates the devices for amplification (6, 8) of the left stereo channel as well as one of the devices for amplification (9) of the right stereo channel.

## Revendications

1. Récepteur radio pour un véhicule, comportant
un récepteur stéréo (2) pour recevoir un signal audio,
un dispositif pour examiner le signal audio reçu (3), qui produit un signal de commande lors de la présence d'un message ou de signaux vocaux,
un ou plusieurs dispositifs pour accroître le niveau de sons à basses fréquences du signal audio (4),
plusieurs dispositifs pour amplifier le signal audio (6, 7, 8, 9) pour la reproduction, et
un dispositif de commande pour la commande du récepteur radio (5),
dans lequel
dès que le dispositif pour examiner le signal audio reçu (3) identifie la présence d'un message ou de signaux vocaux et produit le signal de commande correspondant, le dispositif de commande (5) désactive le ou les dispositifs servant à accroître le niveau des sons à basses fréquences (4), et augmente l'amplification d'une valeur prédéterminée dans au moins l'un des dispositifs d'amplification (6, 7, 8, 9) pour compenser au moins la désactivation du ou des dispositifs pour accroître le niveau des sons à basses fréquences (4), et le dispositif (5) commute le récepteur stéréo (2) sur une réception monophonique.

2. Récepteur radio selon la revendication 1, **caractérisé en ce qu'**il est prévu un autre dispositif, qui détermine la qualité de réception du récepteur stéréo (2) et que le dispositif de commande (5) est alors commuté sur la réception monophonique dans le cas de la présence d'un signal de l'autre unité, qui caractérise une mauvaise réception.

3. Récepteur radio selon la revendication 1 ou 2, **caractérisé en ce que** dans le cas de la présence du signal de commande, le dispositif de commande (5) désactive des régulateurs de tonalités existants de sorte qu'on obtient une reproduction linéaire du signal audio.

4. Récepteur radio selon l'une des revendications 1 à 3, **caractérisé en ce**
**que** plusieurs haut-parleurs ou groupes de haut-parleurs (Vl, VR, Hl, Hr) sont raccordés au récepteur radio et que dans le cas de la présence du signal de commande, le dispositif de commande (5) désactive tous les haut-parleurs ou tous les groupes de haut-parleurs (Vr, Hl, Hr) en dehors des haut-parleurs ou du groupe de haut-parleurs qui sont les plus près de la position du conducteur présent dans le véhicule, par commande des dispositifs d'amplification (6, 7, 8, 9) .

5. Récepteur radio selon l'une des revendications 1 à 3, **caractérisé en ce que** dans le cas de la présence du signal de commande, le dispositif de commande désactive le dispositif (7, 9) d'amplification du canal stéréo de droite ainsi que l'un des dispositifs (8) d'amplification du canal stéréo de gauche.

6. Récepteur radio selon l'une des revendications 1 à 3, **caractérisé en ce que** dans le cas de la présence du signal de commande, le dispositif de commande désactive le dispositif (6, 8) d'amplification du canal stéréo de gauche ainsi que l'un des dispositifs (8) d'amplification du canal stéréo de droite.
